# EUROPEAN PATENT APPLICATION

(11) **EP 4 800 153 A1**
(43) Date of publication of application: **02.09.2026**
(21) Application number: 24882897.2
(22) Date of filing: 25.10.2024
(51) Int. Cl.: C23C 16/18, C07F 11/00, C23C 16/40, C23C 16/34, C23C 16/455, C23C 16/52, H01L 21/285

(54) **MOLYBDENUM PRECURSOR COMPOSITION, MOLYBDENUM-CONTAINING FILM USING SAME, AND METHOD FOR MANUFACTURING SAME**

(30) Priority: 27.10.2023 KR 20230145471
(71) Applicant: Up Chemical Co., Ltd., Pyeongtaek-si, Gyeonggi-do 17749 (KR)
(72) Inventor: KOH, Wonyong, Pyeongtaek-si, Gyeonggi-do 17749 (KR); KOH, Young Dae, Pyeongtaek-si, Gyeonggi-do 17749 (KR); MA, Dong Hwan, Pyeongtaek-si, Gyeonggi-do 17749 (KR); CHO, Ki Uk, Pyeongtaek-si, Gyeonggi-do 17749 (KR)
(74) Representative: Dehns
(86) International application number: PCT/KR2024/016405
(87) International publication number: WO 2025/089871

(57) **Abstract**

This molybdenum precursor composition, comprising a compound represented by chemical formula 1, a compound represented by chemical formula 2, and a compound represented by chemical formula 3 in a specific content ratio, can be effectively produced without using benzene harmful to the human body as a raw material, exists in a liquid state at room temperature, and is thermally stable, thereby being used for manufacturing a molybdenum-containing film.

## Description

### Technical Field

The present invention relates to a molybdenum precursor composition, to a molybdenum-containing film using the same, and to a method for preparing the same.

### Background Art

Molybdenum-containing metal films, molybdenum-containing oxide films, molybdenum-containing carbide films, molybdenum-containing sulfide films, and molybdenum-containing nitride films can be used as diffusion barrier layers of metal wiring, gate metals, electrodes, and the like in a semiconductor process. They are widely used for industrial purposes as hard coating materials, sensors, channel layers, and catalysts. In recent years, research has been actively conducted to utilize the electrical properties of two-dimensional molybdenum sulfide (MoS₂) materials.

A zero-valent molybdenum precursor composition may be used for the purpose of forming a molybdenum-containing film by chemical vapor deposition (CVD) or atomic layer deposition (ALD).

Bis(benzene)molybdenum ((η⁶-C₆H₆)₂Mo; (Bz)₂Mo) and bis(toluene)molybdenum ((η⁶-MeC₆H₅)₂Mo; (MeBz)₂Mo) among the zero-valent molybdenum compounds are solid at room temperature, making them inconvenient to be used in an ALD or CVD equipment used in the manufacture of semiconductor devices. The surface area of a liquid precursor composition contained in a commonly used cylindrical container does not change while the precursor composition is vaporized, whereas the surface area of a solid precursor composition continuously changes, making it difficult to maintain or control the amount of precursor composition gas supplied to an ALD or CVD equipment at a constant level.

Bis(ethylbenzene)molybdenum is liquid at room temperature, making it advantageous for use in an ALD or CVD equipment. In International Publication No. WO 2019/143632 A1, bis(ethylbenzene)molybdenum was used to form a molybdenum carbide film.

T. L. Drake and P. C. Staira formed a molybdenum oxide film by ALD using bis(ethylbenzene)molybdenum purchased from Strem Chemicals, Inc. and water (H₂O) [see J. Vac. Sci. Technol. A 34, 051403 (2016); doi: 10.1116/1.4959532]. However, (EtBz)₂Mo, sold by Strem Chemicals, Inc., is not a single compound; rather, it is a complex mixture [see Strem Catalog # 42-0200 Bis(ethylbenzene)molybdenum [mixture (C₂H₅)ₓC₆H₍₆₋ₓ₎ where x = 0-4 (https://web.archive.org/web/20210619083133/https://www.strem.com/catalog/v/42-0200/43/molybdenum_32877-00-2)]. Since x is 0 to 4, the mixture comprises (C₆H₆)₂Mo, (C₆H₆)Mo[(C₂H₅)C₆H₅], (C₆H₆)Mo[(C₂H₅)₂C₆H₄], (C₆H₆)Mo[(C₂H₅)₃C₆H₃], (C₆H₆)Mo[(C₂H₅)₄C₆H₂], [(C₂H₅)C₆H₅]₂Mo, [(C₂H₅)C₆H₅]Mo[(C₂H₅)₂C₆H₄], [(C₂H₅)C₆H₅]Mo[(C₂H₅)₃C₆H₃], [(C₂H₅)C₆H₅]Mo[(C₂H₅)₄C₆H₂], [(C₂H₅)₂C₆H₄]₂Mo, [(C₂H₅)₂C₆H₄]Mo[(C₂H₅)₃C₆H₃], [(C₂H₅)₂C₆H₄]Mo[(C₂H₅)₄C₆H₂], [(C₂H₅)₃C₆H₃]₂Mo, [(C₂H₅)₃C₆H₃]Mo[(C₂H₅)₄C₆H₂], and [(C₂H₅)₄C₆H₂]₂Mo.

When a composition containing compounds with greatly different molecular weights and vapor pressures, such as [(C₂H₅)₄C₆H₂]₂Mo (x=x'=4), [(C₂H₅)₃C₆H₃]Mo[(C₂H₅)₄C₆H₂] (x=3; x'=4), (C₆H₆)Mo[(C₂H₅)C₆H₅] (x=0; x'=1), and (C₆H₆)₂Mo (x=x'=0), is vaporized and used in an ALD or CVD equipment, the composition changes as the component with a smaller molecular weight and a higher vapor pressure vaporizes first. Therefore, the composition of the precursor composition gas supplied to the ALD or CVD equipment changes during use, and it is difficult to maintain or control the supply amount of the precursor composition gas to be constant.

A method for synthesizing pure (EtBz)₂Mo using bis(benzene)molybdenum [(Bz)₂Mo] and ethylbenzene as raw materials is known. However, benzene, which is used in the synthesis of (Bz)₂Mo, is a carcinogen; thus, exposure to humans is strictly prohibited. It is impossible or very difficult to obtain (Bz)₂Mo commercially.

Accordingly, there is a need for a zero-valent molybdenum precursor composition that does not change its component ratio, or changes its component ratio to a minimum, during vaporization and that can be prepared without using benzene, a substance harmful to the human body. Such a zero-valent molybdenum precursor composition can be used to form molybdenum-containing films required for manufacturing semiconductor devices and the like in an ALD or CVD equipment.

### [Prior art documents]

(Patent Document 1) International Publication No. WO 2019/143632 A1
(Non-patent Document 1) J. Vac. Sci. Technol. A 34, 051403 (2016)

### Disclosure of Invention

### Technical Problem

An object of the present invention is to provide a zero-valent molybdenum precursor composition that is present in a liquid phase at room temperature and is thermally stable.

Another object of the present invention is to provide a method for preparing the molybdenum precursor composition without using benzene, a substance harmful to the human body.

Another object of the present invention is to provide a molybdenum-containing film prepared using the molybdenum precursor composition.

However, the problems to be solved by the present invention are not limited to those mentioned above, and other problems not mentioned will be clearly understood by those skilled in the art from the following description.

### Solution to Problem

The present invention provides a molybdenum precursor composition, which comprises 60% by mole to 99.9% by mole of a compound represented by the following Formula 1, 0.1% by mole to 30% by mole of a compound represented by the following Formula 2, and 0% by mole to 10% by mole of a compound represented by the following Formula 3, based on the total number of moles of the compounds that constitute the composition.

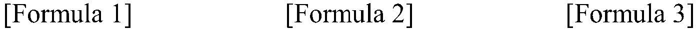

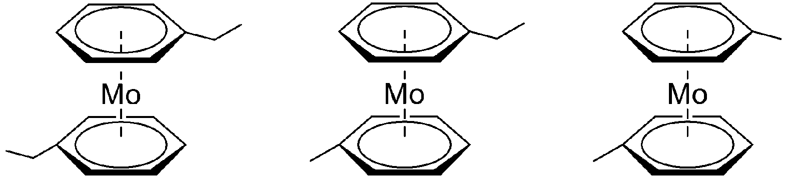

The present invention also provides a molybdenum precursor compound represented by the above Formula 2.

The present invention also provides a method for preparing the molybdenum precursor composition, which comprises reacting a compound represented by the above Formula 3 with ethylbenzene.

The present invention also provides a method for preparing a molybdenum-containing film, which comprises depositing a molybdenum-containing film using the molybdenum precursor composition.

In addition, the present invention provides a molybdenum-containing film formed using the molybdenum precursor composition.

### Advantageous Effects of Invention

The liquid molybdenum precursor composition according to an embodiment of the present invention can be effectively prepared without using benzene, a substance harmful to the human body, as a raw material.

When the liquid molybdenum precursor composition according to an embodiment of the present invention is used in an ALD or CVD equipment using a liquid supply device and a flash vaporizer, the composition of the molybdenum composition gas supplied to the ALD or CVD equipment can be kept constant.

When the liquid molybdenum precursor composition according to an embodiment of the present invention is directly heated to vaporize and used in an ALD or CVD equipment, the change in the composition of the precursor composition gas is sufficiently small such that the film deposition characteristics of the ALD or CVD equipment can be substantially constant while the liquid molybdenum precursor composition is used.

### Brief Description of Drawing

Fig. 1 is a ¹H-NMR spectrum of the liquid molybdenum precursor composition of Example 1.
Fig. 2 is a ¹H-NMR spectrum of the liquid molybdenum precursor composition of Example 2.
Fig. 3 is a ¹H-NMR spectrum showing the change in composition during the process of preparing the liquid molybdenum precursor composition of Example 3.
Fig. 4 shows the results of thermogravimetric analysis (TGA) of the liquid compositions of Examples 1 and 2 and the solid compound of (MeBz)₂Mo.

### Best Mode for Carrying out the Invention

The advantages and features of the present invention and the methods of achieving them will become apparent with reference to the embodiments described hereinafter. However, the present invention is not limited to the embodiments described below, but may be embodied in various different forms. These embodiments are provided so that the disclosure of the present invention will be thorough and complete, and will fully convey the scope of the invention to those skilled in the art. The invention is defined by only the scope of the claims.

In the present specification, singular expressions encompass plural expressions unless the context clearly indicates otherwise.

In the present specification, the term "comprising" is intended to specify particular features, regions, steps, processes, elements, and/or ingredients. Unless specifically stated otherwise, it does not exclude the presence or addition of any other features, regions, steps, processes, elements, and/or ingredients.

In addition, in the present specification, in the case where an element is mentioned to be formed "on" another element, it means not only that one element is directly formed "on" another element, but also that other element(s) is interposed between them.

All numbers and expressions related to the quantities of components, reaction conditions, and the like used herein are to be understood as being modified by the term "about," unless otherwise indicated. It may be understood as a range corresponding to ±5% of the corresponding number.

In the numerical ranges that limit the size, physical properties, or the like of the components described in the present specification, if a numerical range limited only to an upper limit and a numerical range limited only to a lower limit are separately exemplified, it should be understood that a numerical range in which these upper and lower limits are combined is also included in the exemplary range of the present invention.

### Molybdenum precursor composition

According to an embodiment of the present invention, there is provided a molybdenum precursor composition, which comprises 60% by mole to 99.9% by mole of a compound represented by the following Formula 1, 0.1% by mole to 30% by mole of a compound represented by the following Formula 2, and 0% by mole to 10% by mole of a compound represented by the following Formula 3, based on the total number of moles of the compounds that constitute the composition.

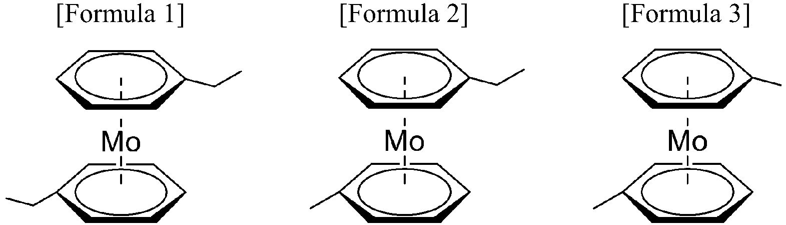

As the contents of the compound represented by Formula 1 (hereinafter also referred to as "(EtBz)₂Mo"), the compound represented by Formula 2 (hereinafter also referred to as "(EtBz)Mo(MeBz)"), and the compound represented by Formula 3 (hereinafter also referred to as "(MeBz)₂Mo") are each controlled to specific ranges, the thermal stability of the molybdenum precursor composition can be greatly enhanced.

When a molybdenum-containing film is formed using the molybdenum precursor composition of the present invention having excellent thermal stability, it is possible to minimize the change of the molybdenum precursor composition in its composition at a high temperature, during the vaporization thereof, and over time thereafter, and the formation of by-products such as thermal decomposition materials.

Thus, the present invention has a great technical significance in that, as it provides a molybdenum precursor composition having the above characteristics, it is possible to obtain a deposition result having more stable and consistent physical properties in a semiconductor process, thereby providing a molybdenum-containing film with guaranteed reproducibility and reliability.

According to an embodiment of the present invention, it is very important to control the content range and content ratio of each compound to achieve the above characteristics.

The content of the (EtBz)₂Mo compound may be, for example, 60% by mole or more, 65% by mole or more, 70% by mole or more, 75% by mole or more, 80% by mole or more, 85% by mole or more, or 90% by mole or more, and may be 99.9% by mole or less, 99% by mole or less, 98% by mole or less, 95% by mole or less, 90% by mole or less, 85% by mole or less, 80% by mole or less, 75% by mole or less, or 70% by mole or less, based on the total number of moles of the compounds that constitute the molybdenum precursor composition.

Specifically, the content of the (EtBz)₂Mo compound may be 60 to 99.9% by mole, 60 to 99% by mole, 60 to 95% by mole, 60 to 90% by mole, 60 to 85% by mole, 60 to 80% by mole, 60 to 75% by mole, 60 to 70% by mole, 65 to 99.9% by mole, 65 to 99% by mole, 65 to 95% by mole, 65 to 90% by mole, 65 to 85% by mole, 65 to 80% by mole, 65 to 75% by mole, 65 to 70% by mole, 70 to 99.9% by mole, 70 to 99% by mole, 70 to 95% by mole, 70 to 90% by mole, 70 to 85% by mole, 70 to 80% by mole, 70 to 75% by mole, 75 to 99.9% by mole, 75 to 99% by mole, 75 to 95% by mole, 75 to 90% by mole, 75 to 85% by mole, 75 to 80% by mole, 80 to 99.9% by mole, 80 to 99% by mole, 80 to 95% by mole, 80 to 90% by mole, 80 to 85% by mole, 85 to 99.9% by mole, 85 to 99% by mole, 85 to 95% by mole, 85 to 90% by mole, 90 to 99.9% by mole, 90 to 99% by mole, 90 to 95% by mole, 95 to 99.9% by mole, or 95 to 99% by mole, based on the total number of moles of the compounds that constitute the molybdenum precursor composition.

The content of the (EtBz)Mo(MeBz) compound may be, for example, 0.1% by mole or more, 1% by mole or more, 3% by mole or more, 5% by mole or more, 10% by mole or more, 15% by mole or more, 20% by mole or more, or 25% by mole or more, and may be 30% by mole or less, 25% by mole or less, 20% by mole or less, 15% by mole or less, 10% by mole or less, 9% by mole or less, 8% by mole or less, or 7% by mole or less, based on the total number of moles of the compounds that constitute the molybdenum precursor composition.

Specifically, the content of the (EtBz)Mo(MeBz) compound may be 0.1 to 30% by mole, 0.1 to 25% by mole, 0.1 to 20% by mole, 0.1 to 15% by mole, 0.1 to 10% by mole, 1 to 30% by mole, 1 to 25% by mole, 1 to 20% by mole, 1 to 15% by mole, 1 to 10% by mole, 3 to 30% by mole, 3 to 25% by mole, 3 to 20% by mole, 3 to 15% by mole, 3 to 10% by mole, 5 to 30% by mole, 5 to 25% by mole, 5 to 20% by mole, 5 to 15% by mole, 5 to 10% by mole, 10 to 30% by mole, 10 to 25% by mole, 10 to 20% by mole, 10 to 15% by mole, 15 to 30% by mole, 15 to 25% by mole, 15 to 20% by mole, 20 to 30% by mole, 20 to 25% by mole, or 25 to 30% by mole, based on the total number of moles of the compounds that constitute the molybdenum precursor composition.

The content of the (MeBz)₂Mo compound may be, for example, 0% by mole or more, greater than 0% by mole, 0.1% by mole or more, 0.5% by mole or more, 1% by mole or more, 3% by mole or more, 5% by mole or more, or 7% by mole or more, and may be 10% by mole or less, 9% by mole or less, 7% by mole or less, 5% by mole or less, 3% by mole or less, 2% by mole or less, 1% by mole or less, or 0.8% by mole or less, based on the total number of moles of the compounds that constitute the molybdenum precursor composition.

Specifically, the content of the (MeBz)₂Mo compound may be 0 to 10% by mole, 0 to 9% by mole, 0 to 7% by mole, 0 to 5% by mole, 0 to 2% by mole, 0 to 1% by mole, 0 to 0.8% by mole, 0.1 to 10% by mole, 0.1 to 9% by mole, 0.1 to 7% by mole, 0.1 to 5% by mole, 0.1 to 2% by mole, 0.1 to 1% by mole, 0.1 to 0.8% by mole, 0.5 to 10% by mole, 0.5 to 9% by mole, 0.5 to 7% by mole, 0.5 to 5% by mole, 0.5 to 2% by mole, 0.5 to 1% by mole, 0.5 to 0.8% by mole, 1 to 10% by mole, 1 to 9% by mole, 1 to 7% by mole, 1 to 5% by mole, 1 to 2% by mole, 3 to 10% by mole, 3 to 9% by mole, 3 to 7% by mole, 3 to 5% by mole, 5 to 10% by mole, 5 to 9% by mole, or 5 to 7% by mole, based on the total number of moles of the compounds that constitute the molybdenum precursor composition.

In an embodiment, the molybdenum precursor composition comprises 80% by mole to 99.9% by mole of the (EtBz)₂Mo compound, 0.1% by mole to 20% by mole of the (EtBz)Mo(MeBz) compound, and 0% by mole to 5% by mole of the (MeBz)₂Mo compound, based on the total number of moles of the compounds that constitute the composition.

In another embodiment, the molybdenum precursor composition comprises 80% by mole to 99.9% by mole of the (EtBz)₂Mo compound, 0.1% by mole to 20% by mole of the (EtBz)Mo(MeBz) compound, and 0% by mole to 2% by mole of the (MeBz)₂Mo compound, based on the total number of moles of the compounds that constitute the composition.

In particular, according to an embodiment of the present invention, it is important to control the content of the (MeBz)₂Mo compound. That is, since the (MeBz)₂Mo compound tends not to completely vaporize and leaves a residue, it is preferably employed in a minimal amount. If the (MeBz)₂Mo compound is excessively employed, it may decompose during the vaporization process, which may deteriorate the properties of the film formed by the CVD or ALD method or have an adverse impact on the process reproducibility.

The molybdenum precursor composition according to an embodiment of the present invention may not substantially comprise the (MeBz)₂Mo compound.

In such a case, it may be more advantageous in achieving the object desired in the present invention since the molybdenum precursor composition is very thermally stable.

The respective contents of the (EtBz)₂Mo compound, the (EtBz)Mo(MeBz) compound, and the (MeBz)₂Mo compound can be calculated by, for example, obtaining the area ratio of peaks at specific positions appearing during ¹H-NMR measurement.

Specifically, the respective contents of the compounds contained in the molybdenum precursor composition according to an embodiment of the present invention may be calculated by obtaining the area ratio of a peak of about 2.10 ppm, a peak of about 1.89 ppm, a peak of about 1.86 ppm, and the like measured by ¹H-NMR under the conditions of 400 MHz, C₆D₆, and 25°C.

For example, when the molybdenum precursor composition according to an embodiment of the present invention is measured by ¹H-NMR under the conditions of 400 MHz, C₆D₆, and 25°C, the peak of the CH₃- group in (MeBz)₂Mo at δ 1.86 ppm and the peak of the CH₃- group in MeBz of (EtBz)Mo(MeBz) at δ 1.89 ppm are distinct, while the peaks of the -CH₂- groups of the ethyl groups in (EtBz)Mo(MeBz) and (EtBz)₂Mo may overlap at δ 2.10 ppm. In a mixture with a mole ratio of (EtBz)₂Mo:(EtBz)Mo(MeBz):(MeBz)₂Mo = y:x:1, the expected NMR peak area ratio at positions δ 1.86, 1.89, and 2.10 is 6:3x:(2x+4y). Thus, x and y are calculated from the measured NMR peak area ratio to obtain the mole ratio of y:x:1.

The molybdenum precursor composition according to an embodiment of the present invention may be in a liquid phase at 25°C. Accordingly, the molybdenum precursor composition is advantageously used in chemical vapor deposition (CVD) or atomic layer deposition (ALD) used in the manufacture of semiconductor devices.

### Method for preparing a molybdenum precursor composition

According to an embodiment of the present invention, there is provided a method for preparing a molybdenum precursor composition, which comprises reacting a compound of (MeBz)₂Mo represented by the above Formula 3 with ethylbenzene (EtBz). A method for preparing the (MeBz)₂Mo compound is known (M. L. H. Green and W. E. Silverthorn, J. Chem. SOC., Dalton Trans. 1973, 301-306.; Thomas Schmidt and Richard Goddard, J. Chem. Soc., Dalton Trans., 1995, 1563-1568).

A molybdenum precursor composition prepared in this manner has the composition and characteristics as described above. Specifically, the molybdenum precursor composition prepared by the above method comprises 60% by mole to 99.9% by mole of the (EtBz)₂Mo compound, 0.1% by mole to 30% by mole of the (EtBz)Mo(MeBz) compound, and 0% by mole to 10% by mole of the (MeBz)₂Mo compound, based on the total number of moles of the compounds that constitute the composition.

According to an embodiment of the present invention, toluene (methylbenzene; MeBz) can be replaced by ethylbenzene (EtBz) in (MeBz)₂Mo compound using ethylbenzene (EtBz) as a solvent. When used as a solvent, ethylbenzene (EtBz) is used in an excess sufficient to replace all of the toluene (MeBz) present in the (MeBz)₂Mo compound.

The temperature in the above reaction may be, for example, 60°C to 180°C, 60°C to 160°C, 70°C to 150°C, or 80°C to 140°C. The time required for the above reaction may be, for example, about 10 hours to 100 hours, about 20 hours to 100 hours, or about 20 hours to 80 hours.

According to an embodiment of the present invention, the reaction of the (MeBz)₂Mo compound with ethylbenzene may involve a reflux reaction. For example, the reflux reaction may be carried out at 100°C to 180°C for 10 hours to 100 hours. In the method for preparing a molybdenum precursor composition according to an embodiment of the present invention, the reflux reaction may be carried out once or twice.

According to an embodiment of the present invention, an exchange reaction between the (MeBz)₂Mo compound and ethylbenzene produces (EtBz)Mo(MeBz) compound, and a further exchange reaction between the (EtBz)Mo(MeBz) compound and ethylbenzene produces (EtBz)₂Mo compound.

As shown in the following Reaction Schemes 1 and 2, an arene exchange reaction can be carried out in which toluene (MeBz) in the (MeBz)₂Mo compound is replaced with ethylbenzene (EtBz). Since the following exchange reactions may be carried out in both forward and reverse reactions, the by-product of the reaction, toluene (MeBz), must be removed to promote the production of the (EtBz)₂Mo compound.

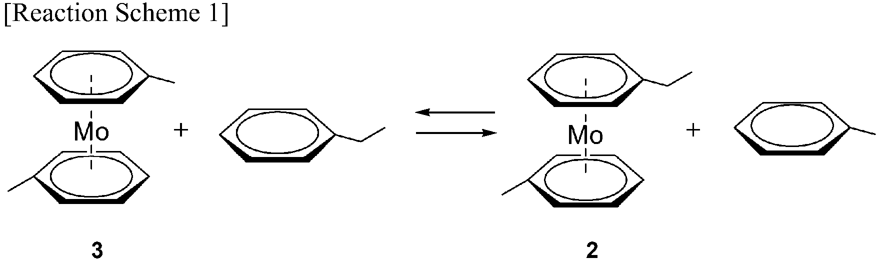

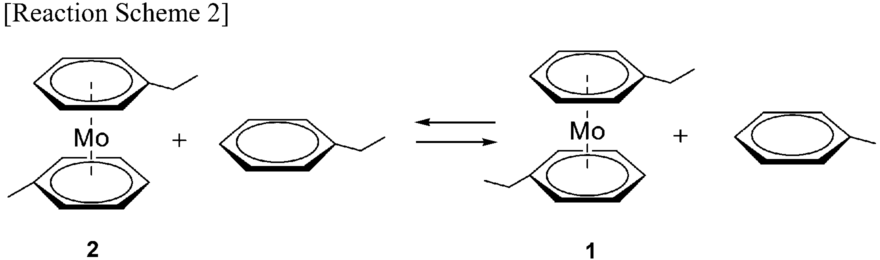

However, since the boiling points of toluene and ethylbenzene are very similar, it may be difficult to completely remove toluene. Thus, when the (MeBz)₂Mo compound and ethylbenzene are used as raw materials to produce (EtBz)₂Mo compound, it may be impossible to obtain the (EtBz)₂Mo compound in a pure state, or the reaction time may be too long to effectively produce the (EtBz)₂Mo compound commercially.

The reaction would not be 100% completed as described above. Thus, when a mixture of (EtBz)₂Mo compound, (EtBz)Mo(MeBz) compound, and (MeBz)₂Mo compound is obtained, and when the (EtBz)Mo(MeBz) compound and the (MeBz)₂Mo compound are removed from the mixture by fractional distillation to produce (EtBz)₂Mo compound with high purity, it is difficult to avoid that the (EtBz)₂Mo compound is removed together with the (EtBz)Mo(MeBz) compound. As a result, it is difficult to effectively produce (EtBz)₂Mo compound commercially.

However, it is possible to form a molybdenum-containing film by using a liquid molybdenum precursor composition mainly comprising (EtBz)₂Mo compound and partially comprising (EtBz)Mo(MeBz) compound or (MeBz)₂Mo compound in an ALD or CVD equipment.

As an example, a liquid molybdenum precursor composition supplied at a constant flow rate using a liquid delivery system can be vaporized in a flash to supply a molybdenum composition gas to an ALD or CVD equipment. In such a case, if the composition of the liquid precursor composition supplied to the flash evaporator is constant, the composition of the molybdenum composition gas supplied to the ALD or CVD equipment can also be constant. A liquid molybdenum precursor composition may also be used in which a low-viscosity solvent is mixed to lower the viscosity of the liquid molybdenum precursor composition so as to make it suitable for use in a liquid delivery system.

In addition, according to an embodiment of the present invention, the method for preparing a liquid molybdenum precursor composition may further comprise distillation and/or filtration after the reaction of the (MeBz)₂Mo compound and ethylbenzene.

According to an embodiment of the present invention, as the method for preparing a liquid molybdenum precursor composition is used, the compounds of (EtBz)₂Mo, (EtBz)Mo(MeBz), and (MeBz)₂Mo can each be adjusted to have the specific content ranges. In particular, the content of the (MeBz)₂Mo compound can be adjusted to 10% by mole or less.

In addition, according to an embodiment of the present invention, as the method for preparing a liquid molybdenum precursor composition is used, it may be controlled so as not to comprise the (MeBz)₂Mo compound as much as possible.

In such a case, it is possible to provide a very thermally stable molybdenum precursor composition. When a molybdenum-containing film is formed using the same, it is possible to prevent the molybdenum precursor composition from changing in its composition during the vaporization of the molybdenum precursor composition, or thereafter, and to minimize the formation of a by-product such as thermal decomposition materials. As a result, it is possible to obtain a deposition result having stable and consistent physical properties in a semiconductor process, thereby providing a molybdenum-containing film with guaranteed reproducibility and reliability.

According to an embodiment of the present invention, there is provided a molybdenum precursor composition comprising (EtBz)Mo(MeBz).

### Method for preparing a molybdenum-containing film

According to an embodiment of the present invention, there is provided a method for preparing a molybdenum-containing film, which comprises depositing a molybdenum-containing film using the liquid molybdenum precursor composition.

Specifically, the method according to an embodiment comprises depositing a molybdenum-containing film on a substrate (board) using a molybdenum precursor composition comprising 60% by mole to 99.9% by mole of (EtBz)₂Mo compound, 0.1% by mole to 30% by mole of (EtBz)Mo(MeBz) compound, and 0% by mole to 10% by mole of (MeBz)₂Mo compound, based on the total number of moles of the compounds that constitute the composition.

The molybdenum-containing film may be deposited on a substrate.

The substrate may be a molybdenum semiconductor wafer, a compound semiconductor wafer, and plastic boards (PI, PET, and PES), but it is not limited thereto. A substrate having holes or grooves may be used, and a porous substrate having a large surface area may be used.

The liquid molybdenum precursor composition according to an embodiment of the present invention can be vaporized at a constant composition without leaving a residue, thereby enabling efficient deposition of a molybdenum-containing film in a variety of temperature ranges by CVD and ALD. In particular, it is possible to uniformly deposit a molybdenum-containing film even on a substrate having patterns (grooves) or fine irregularities on its surface, a porous substrate, or a plastic substrate having a thickness of several micrometers to several tens nanometers in a temperature range of 300°C to 550°C.

The deposition method of a film may use any methods and/or apparatuses known in the art; if necessary, it may be carried out using one or more additional reaction gases or the like.

According to an embodiment of the present invention, in the method for depositing a molybdenum-containing film, a substrate is accommodated in a reaction chamber, and the liquid molybdenum precursor compound is then delivered onto the substrate using a transport gas or a diluent gas to deposit the molybdenum-containing film.

Specifically, the deposition may be carried out at a temperature of 300°C to 550°C, 350°C to 550°C, 350°C to 500°C, or 350°C to 450°C, by chemical vapor deposition (CVD), specifically organometallic chemical vapor deposition (MOCVD), or atomic layer deposition (ALD).

According to an embodiment of the present invention, the deposition of the molybdenum-containing film may be carried out at a temperature of 300°C to 550°C by chemical vapor deposition (CVD) or atomic layer deposition (ALD).

In particular, it is possible to uniformly deposit a molybdenum-containing film even on a substrate having patterns (grooves) on its surface, a porous substrate, or a plastic substrate in a temperature range of 300°C to 550°C. It is possible to deposit a uniform film on the substrate, covering the deepest surface of fine patterns (grooves) and the upper surface of the fine patterns (grooves) having an aspect ratio of about 1 to 50 or more and a width of 10 nm to 1 µm or less.

Here, the deposition carried out at the above temperature allows it to be applied to memory devices, logic devices, and display devices. Since the process temperature is broad, the deposition is preferably conducted in the above deposition temperature in order to be applicable to various fields.

In addition, the atomic layer deposition may comprise a plasma enhanced atomic layer deposition (PEALD).

In addition, it is preferable to use at least one mixed gas selected from the group consisting of argon (Ar), nitrogen (N₂), helium (He), and hydrogen (H₂) as the transport gas or diluent gas.

In addition, the method of delivering the liquid molybdenum precursor composition onto the substrate may be at least one method selected from the group consisting of a bubbling method in which the liquid molybdenum precursor composition is forcibly vaporized using a transport gas or a diluent gas, a liquid delivery system (LDS) method for supplying it in a liquid phase at room temperature to be vaporized through a vaporizer; a vapor flow control (VFC) method for directly supplying the precursor using its vapor pressure; and a bypass method.

For example, if the vapor pressure is high, a vapor flow control method may be used. If the vapor pressure is low, at least one supply method selected from the group consisting of a bypass method of vaporization by heating the vessel; and a method of bubbling using argon (Ar) or nitrogen (N₂) gas may be used.

More specifically, the delivery method comprises a bubbling method or a bypass method of vaporization by heating, in which the bubbling method may be carried out using a transport gas in a temperature range of 100°C to 150°C and 0.1 Torr to 10 Torr, and the bypass method of vaporization by heating may be carried out using a vapor pressure of 0.1 Torr to 1.5 Torr in a temperature range of room temperature to 100°C.

In addition, in order to vaporize the liquid molybdenum precursor composition, for example, argon (Ar) or nitrogen (N₂) gas may be used for the transportation thereof, thermal energy or plasma may be used during deposition, or a bias may be applied on the substrate.

Meanwhile, in order to deposit a molybdenum-containing metal film during the deposition of a film, at least one selected from the group consisting of hydrogen (H₂), neutral nitrogen (N₂), and ammonia (NH₃) may be used as a reaction gas.

In addition, in order to deposit a molybdenum-containing oxide film during the deposition of a film, at least one selected from the group consisting of water vapor (H₂O), oxygen (O₂), oxygen plasma (O₂ plasma), nitric oxide (NO, N₂O), nitric oxide plasma (N₂O plasma), oxygen nitrate (N₂O₂), hydrogen peroxide (H₂O₂), and ozone (O₃) may be used as a reaction gas.

In addition, in order to deposit, for example, a molybdenum-containing nitride film during the deposition of a film, at least one selected from the group consisting of ammonia (NH₃), ammonia plasma (NH₃ plasma), hydrazine (N₂H₄), and nitrogen plasma (N₂ plasma) may be used as a reaction gas.

The method according to an embodiment may comprise supplying the liquid molybdenum precursor composition in a gas phase to deposit a molybdenum-containing film on a substrate. Specifically, the molybdenum composition gas vaporized by directly heating a container containing the liquid molybdenum precursor composition can be supplied to an ALD or CVD equipment.

When a composition containing compounds with different vapor pressures is vaporized and used in an ALD or CVD equipment, the component ratio of the composition continuously changes as the component with the higher vapor pressure vaporizes first. However, the vapor pressures of the (EtBz)₂Mo compound and the (EtBz)Mo(MeBz) compound are very similar, and the vapor pressures of the (EtBz)Mo(MeBz) compound and the (MeBz)₂Mo compound are also very similar; thus, a liquid molybdenum precursor composition composed of a sufficiently small amount of the (EtBz)Mo(MeBz) or (MeBz)₂Mo compound and composed mostly of the (EtBz)₂Mo compound can have a sufficiently small change in the components of the composition during vaporization. Accordingly, the changes in the composition during vaporization do not substantially affect the film deposition by ALD or CVD, so that the film properties deposited using the liquid molybdenum precursor composition may not substantially change.

As described above, when the liquid molybdenum precursor composition according to an embodiment of the present invention is used, the composition of the molybdenum composition gas supplied to an ALD or CVD equipment can be kept constant, making the film deposition characteristics substantially constant.

### Molybdenum-containing film

According to an embodiment of the present invention, there is provided a molybdenum-containing film deposited using the liquid molybdenum precursor composition.

The molybdenum-containing film may have a thickness of several nanometers (nm) to several micrometers (µm) and may be variously applied depending on the application purposes.

For example, the thickness of the molybdenum-containing film may be about 1 nm or more, about 5 nm or more, about 10 nm or more, about 15 nm or more, about 20 nm or more, about 25 nm or more, about 30 nm or more, about 35 nm or more, about 40 nm or more, about 45 nm or more, or about 50 nm or more. In addition, the thickness of the molybdenum-containing film may be about 500 nm or less, about 450 nm or less, about 400 nm or less, about 350 nm or less, about 300 nm or less, about 250 nm or less, about 200 nm or less, about 150 nm or less, or about 100 nm or less.

Specifically, the thickness of the molybdenum-containing film may be variously selected from about 1 nm to about 500 nm.

According to an embodiment of the present invention, the molybdenum-containing film may be formed on a substrate comprising irregularities or patterns (grooves) having an aspect ratio of 1 to 50 and a width of 10 nm to 1 µm, or less.

Specifically, the aspect ratio may be about 1 or more, about 2 or more, about 3 or more, about 5 or more, about 7 or more, about 10 or more, or about 15 or more. In addition, the aspect ratio may be about 50 or less, about 45 or less, about 40 or less, about 35 or less, about 30 or less, about 25 or less, or about 20 or less.

In addition, the width may be about 10 nm or more, about 15 nm or more, about 20 nm or more, about 25 nm or more, about 30 nm or more, about 35 nm or more, or about 40 nm or more. In addition, the width may be about 1 µm or less, about 900 nm or less, about 800 nm or less, about 700 nm or less, about 600 nm or less, about 500 nm or less, or about 450 nm or less.

The molybdenum-containing film may be at least one selected from the group consisting of a molybdenum-containing metal film, a molybdenum-containing oxide film, a molybdenum-containing carbide film, a molybdenum-containing sulfide film, and a molybdenum-containing nitride film.

In addition, the molybdenum-containing film according to an embodiment of the present invention may have a low resistivity (µΩ·cm) of 1,200 µΩ·cm or less.

The molybdenum-containing film may have different resistivities depending on temperature.

Specifically, the resistivity of the molybdenum-containing film at about 350°C may be, for example, 400 to 1,200 µΩ·cm, for example, 450 to 1,200 µΩ·cm, for example, 500 to 1,200 µΩ·cm, for example, 600 to 1,200 µΩ·cm, or, for example, 700 to 1,200 µΩ·cm.

As another example, the resistivity of the molybdenum-containing film at about 400°C may be, for example, 400 to 1,200 µΩ·cm, for example, 400 to 1,000 µΩ·cm, for example, 400 to 900 µΩ·cm, for example, 400 to 800 µΩ·cm, or, for example, 500 to 800 µΩ·cm.

As still another example, the resistivity of the molybdenum-containing film at about 450°C may be, for example, 400 to 1,200 µΩ·cm, for example, 400 to 900 µΩ·cm, for example, 300 to 800 µΩ·cm, for example, 300 to 700 µΩ·cm, for example, 300 to 600 µΩ·cm, or, for example, 300 to 500 µΩ·cm.

As still another example, the resistivity of the molybdenum-containing film at about 500°C may be, for example, 300 to 1,200 µΩ·cm, for example, 300 to 1,000 µΩ·cm, for example, 300 to 900 µΩ·cm, for example, 300 to 800 µΩ·cm, or, for example, 300 to 700 µΩ·cm.

Thus, the molybdenum-containing film can be used as a gate electrode, a diffusion barrier layer, and a capacitor electrode used in DRAM or NAND flashes and logic devices that require low resistivity, and it can be variously applied depending on the application purposes.

### Mode for the Invention

Hereinafter, the present invention will be described in detail with reference to examples. The following examples are only illustrative of the present invention, and the scope of the present invention is not limited thereto.

### Example 1: Preparation of a liquid molybdenum precursor composition

A flame-dried 2-liter Schlenk flask was charged with about 200 g (0.74 mole) of bis(toluene)molybdenum ((MeBz)₂Mo) and about 1,000 ml of ethylbenzene (EtBz), which was maintained at room temperature. A condenser was connected to the flask, and the mixture in the flask was heated to 140°C or higher and then refluxed for 30 hours. After 30 hours, the solid by-product formed during the reaction was filtered off, and the solvent and volatile by-product were distilled off under a reduced pressure to obtain about 70 g (0.23 mole) of a green liquid (a yield of about 31% based on Mo(MeBz)₂).

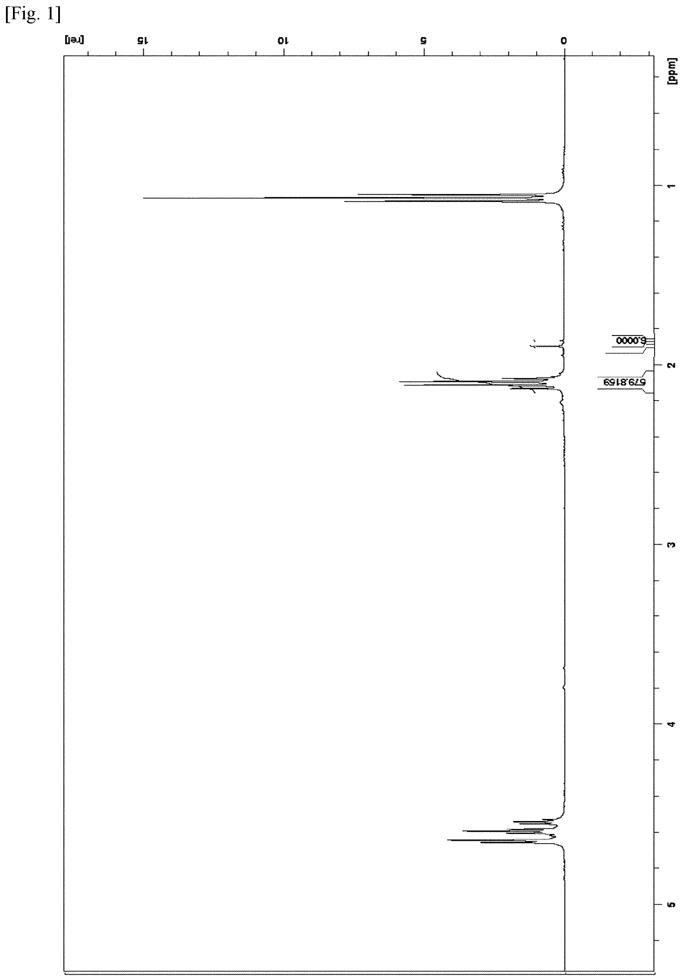

The ¹H-NMR spectrum of the precursor composition obtained in Example 1 is shown in Fig. 1. The results of analyzing the NMR peaks in Fig. 1 are as follows.
Boiling point (bp): 150°C (0.3 Torr)
¹H-NMR (400 MHz, C₆D₆, 25°C):
(EtBz)₂Mo δ 1.06 (t, 6H, (C*H*₃CH₂C₆H₅)₂Mo)
(EtBz)₂Mo δ 2.10 (m, 4H, (CH₃C*H*₂C₆H₅)₂Mo)
(EtBz)₂Mo δ 4.50-4.66 (m, 10H, (CH₃CH₂C₆*H*₅)₂Mo)
(EtBz)Mo(MeBz) δ 1.06 (t, 3H, (C*H*₃CH₂C₆H₅)Mo(CH₃C₆H₅))
(EtBz)Mo(MeBz) δ 1.89 (s, 3H, (CH₃CH₂C₆H₅)Mo(C*H*₃C₆H₅))
(EtBz)Mo(MeBz) δ 2.07 (t, 2H, (CH₃C*H*₂C₆H₅)Mo(CH₃C₆H₅))
(EtBz)Mo(MeBz) δ 4.50-4.66 (m, 5H, (CH₃CH₂C₆*H*₅)Mo(CH₃C₆H₅))
(EtBz)Mo(MeBz) δ 4.50-4.66 (m, 5H, (CH₃CH₂C₆H₅)Mo(CH₃C₆*H*₅))
(MeBz)₂Mo δ 1.86 (t, 6H, (C*H*₃C₆H₅)₂Mo)
(MeBz)₂Mo δ 4.50-4.66 (m, 10H, (CH₃C₆*H*₅)₂Mo)

The CH₃- group peak of (MeBz)₂Mo at δ 1.86 ppm and the CH₃- group peak of (EtBz)Mo(MeBz) at δ 1.89 ppm were distinct, while the -CH₂- group peaks of the ethyl groups of (EtBz)Mo(MeBz) and (EtBz)₂Mo overlapped at δ 2.10 ppm.

The area ratio of the three peaks (δ 1.86 ppm, δ 1.89 ppm, and δ 2.10 ppm) in the NMR spectrum of Fig. 1 was 6:31:580.

In a mixture with a mole ratio of (EtBz)₂Mo:(EtBz)Mo(MeBz):(MeBz)₂Mo = y:x:1, the expected NMR peak area ratio at positions δ 1.86, 1.89, and 2.10 is 6:3x:(2x+4y).

The mole ratio of each component calculated from this was (EtBz)₂Mo:(EtBz)Mo(MeBz):(MeBz)₂Mo = 140:10.3:1, which was converted to mole percent of 92.5% by mole:6.8% by mole:0.7% by mole.

### Example 2: Preparation of a liquid molybdenum precursor composition

A flame-dried 2-liter Schlenk flask was charged with about 200 g (0.74 mole) of (MeBz)₂Mo and about 1,000 ml of ethylbenzene (EtBz), which was maintained at room temperature. A condenser was connected to the flask, and the mixture in the flask was heated to 140°C or higher and then refluxed for 15 hours. After 15 hours, the solid by-product formed during the reaction was filtered off, and the solvent and volatile by-product were distilled off under a reduced pressure to obtain about 114 g of a green liquid.

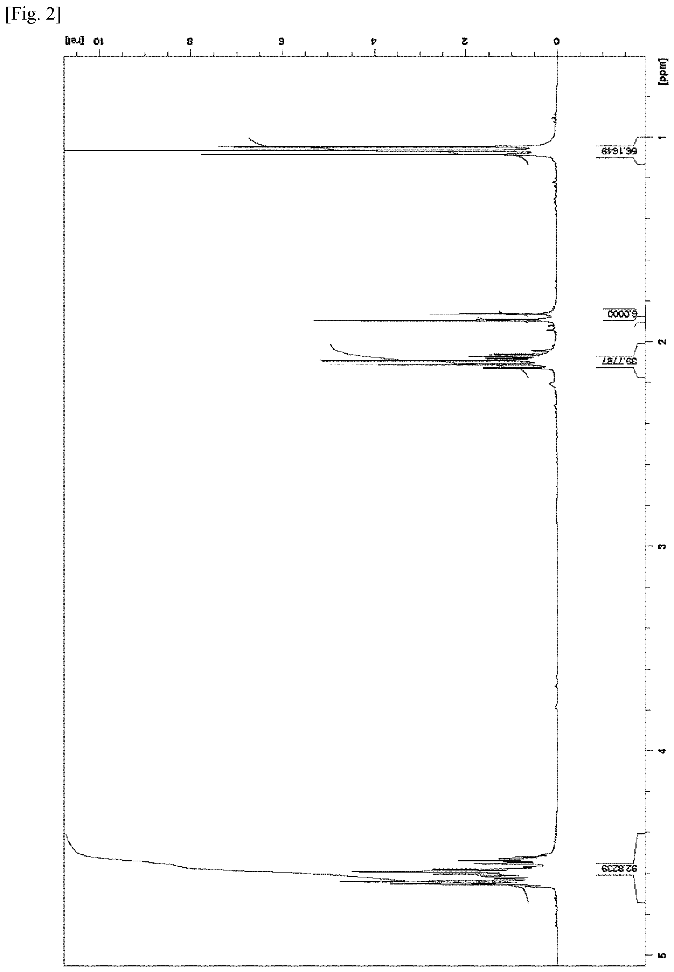

The ¹H-NMR spectrum of the precursor composition obtained in Example 2 is shown in Fig. 2.

The area ratio of the three peaks (δ 1.86 ppm, δ 1.89 ppm, and δ 2.10 ppm) in Fig. 2 was 6:10.2:39.8.

The mole ratio of each component calculated from this was (EtBz)₂Mo:(EtBz)Mo(MeBz):(MeBz)₂Mo = 8.25:3.4:1, which was converted to mole percent of 65.2% by mole:26.9% by mole:7.9% by mole.

### Example 3: Change in composition during the preparation of a liquid molybdenum precursor composition

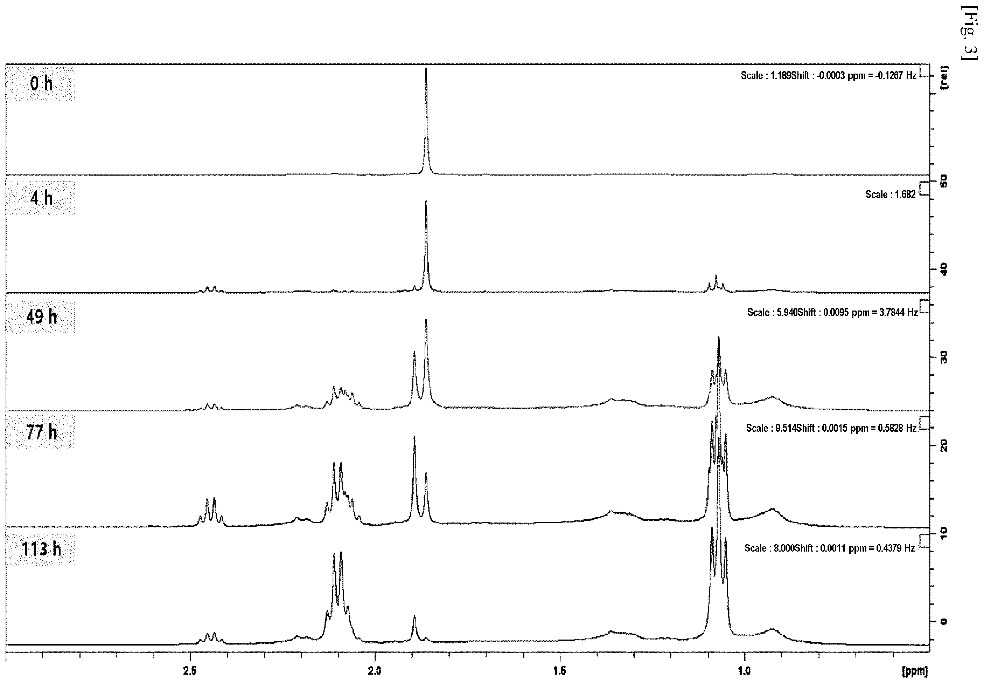

A flame-dried 2-liter Schlenk flask was charged with about 120 g (0.43 mole) of (MeBz)₂Mo and about 1,500 ml of ethylbenzene (EtBz), which was maintained at room temperature. A condenser was connected to the flask, and the mixture in the flask was heated to 140°C or higher and then refluxed. A small amount of the solution was collected at 4 hours, 49 hours, 77 hours, and 113 hours, and depressurized to remove toluene and ethylbenzene. The results of ¹H-NMR measurement are shown in Fig. 3.

The area ratio of the three peaks (δ 1.86 ppm, δ 1.89 ppm, and δ 2.10 ppm) attributed to (MeBz)₂Mo, (EtBz)Mo(MeBz), and (EtBz)₂Mo in the ¹H-NMR spectrum of Fig. 3 is shown in Table 1 below. An NMR peak appeared at 2.44 ppm since EtBz not coordinated to the Mo metal atom was not completely removed. However, this did not affect the determination of the compositions of (MeBz)₂Mo, (EtBz)Mo(MeBz), and (EtBz)₂Mo from the three peaks at δ 1.86 ppm, δ 1.89 ppm, and δ 2.10 ppm.

**[Table 1]**

| Reflux time (hr) | Area ratio of NMR peaks | | |
|---|---|---|---|
| | (MeBz)₂Mo | (EtBz)Mo(MeBz) | (EtBz)Mo(MeBz) and (EtBz)₂Mo |
| | (δ 1.86 ppm) | (δ 1.89 ppm) | (δ 2.10 ppm) |
| 0 | 6 | 0 | 0 |
| 4 | 6 | 0.49 | 1.46 |
| 49 | 6 | 3.86 | 7.97 |
| 77 | 6 | 9.43 | 27.4 |
| 113 | 6 | 24.4 | 228.1 |

The mole ratio and mole percentage calculated from the above with respect to the reaction time are shown in Table 2 below. As the reaction progressed, the ratios of (EtBz)Mo(MeBz) and (EtBz)₂Mo increased as MeBz in (MeBz)₂Mo was replaced with EtBz. Eventually, after 113 hours, the ratio of (EtBz)Mo(MeBz) decreased, and the ratio of (EtBz)₂Mo increased to 85.3% by mole.

**[Table 2]**

| Reflux time (hr) | Mole ratio | | | Mole percentage (% by mole) | | |
|---|---|---|---|---|---|---|
| | (EtBz)₂Mo | (EtBz)Mo(MeBz) | (MeBz)₂Mo | (EtBz)₂Mo | (EtBz)Mo(MeBz) | (MeBz)₂Mo |
| 0 | 0.0 | 0.0 | 1 | 0.0% | 0.0% | 100.0% |
| 4 | 0.3 | 0.2 | 1 | 19.6% | 11.3% | 69.1% |
| 49 | 1.3 | 1.3 | 1 | 37.1% | 35.4% | 27.5% |
| 77 | 5.3 | 3.1 | 1 | 56.0% | 33.4% | 10.6% |
| 113 | 53.0 | 8.1 | 1 | 85.3% | 13.1% | 1.6% |

### Test Example 1: Thermogravimetric analysis (TGA)

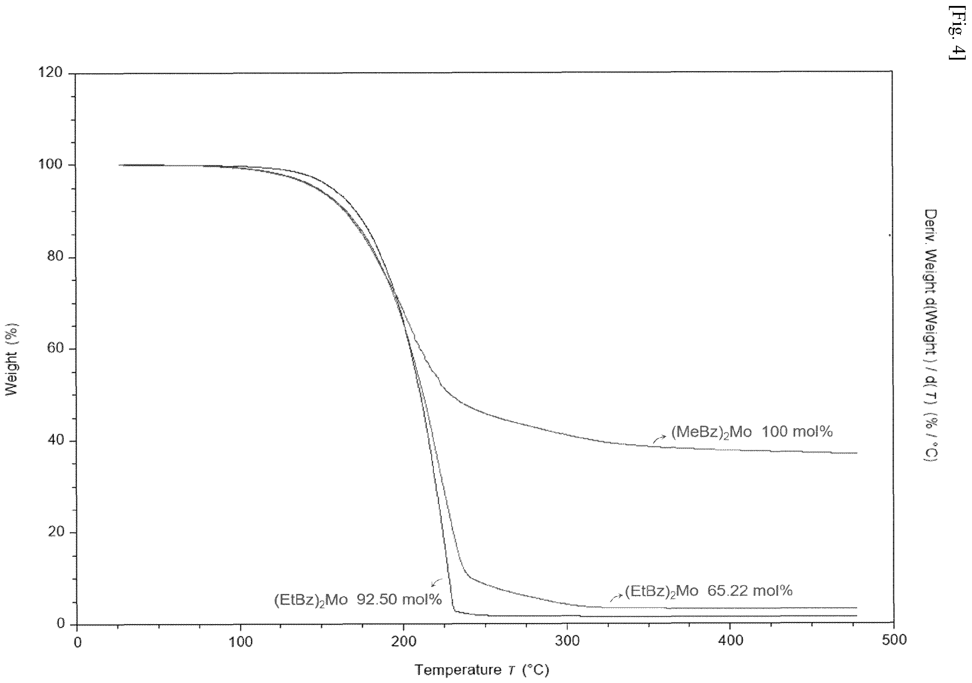

Thermal gravimetry analysis (TGA) was carried out on the composition of Example 1 (92.50% by mole of (EtBz)₂Mo), the composition synthesized in Example 2 (65.22% by mole of (EtBz)₂Mo), and commercial bis(toluene)molybdenum ((MeBz)₂Mo) in an inert gas atmosphere in a glove box. The results are shown in Fig. 4.

As shown in Fig. 4, bis(toluene)molybdenum left about 40% of a residue after vaporization, which indicates that it is unsuitable for use as a molybdenum-containing precursor in chemical vapor deposition or atomic layer deposition. In contrast, the compositions of Examples 1 and 2 were vaporized with almost no residue, which indicates that they are suitable for use as a molybdenum-containing precursor in chemical vapor deposition or atomic layer deposition.

## Claims

1. A molybdenum precursor composition, which comprises 60% by mole to 99.9% by mole of a compound represented by the following Formula 1, 0.1% by mole to 30% by mole of a compound represented by the following Formula 2, and 0% by mole to 10% by mole of a compound represented by the following Formula 3, based on the total number of moles of the compounds that constitute the composition:

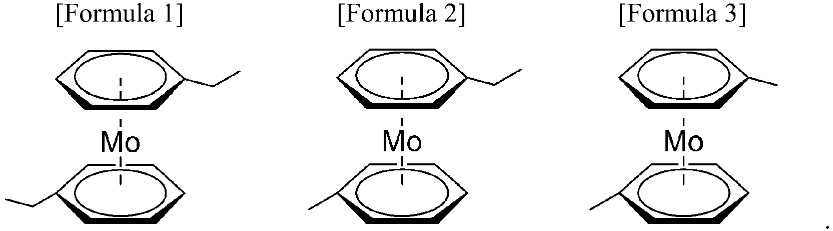

2. The molybdenum precursor composition of claim 1, which comprises 80% to 99.9% by mole of the compound represented by the above Formula 1, 0.1% by mole to 20% by mole of the compound represented by the above Formula 2, and 0% by mole to 2% by mole of the compound represented by the above Formula 3, based on the total number of moles of the compounds that constitute the composition.

3. The molybdenum precursor composition of claim 1, which does not substantially comprise the compound represented by the above Formula 3.

4. The molybdenum precursor composition of claim 1, wherein the molybdenum precursor composition is in a liquid phase at 25°C.

5. A molybdenum precursor compound, which is represented by the following Formula 2:

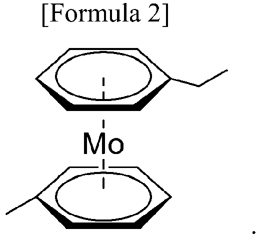

6. A method for preparing a molybdenum precursor composition, which comprises reacting a compound represented by the following Formula 3 with ethylbenzene,
wherein the molybdenum precursor composition comprises 60% by mole to 99.9% by mole of a compound represented by the following Formula 1, 0.1% by mole to 30% by mole of a compound represented by the following Formula 2, and 0% by mole to 10% by mole of the compound represented by the following Formula 3, based on the total number of moles of the compounds that constitute the composition:

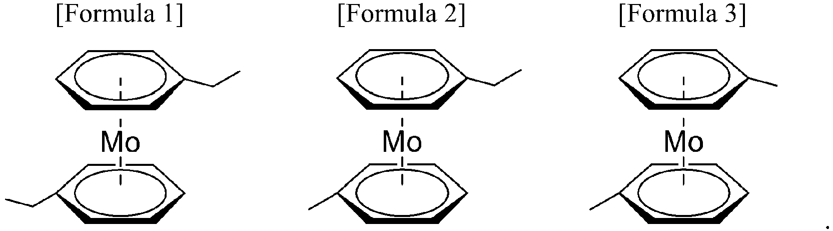

7. The method for preparing a molybdenum precursor composition of claim 6, wherein an exchange reaction between the compound represented by the above Formula 3 and ethylbenzene produces the compound represented by the above Formula 2, and a further exchange reaction between the compound represented by the above Formula 2 and ethylbenzene produces the compound represented by the above Formula 1.

8. The method for preparing a molybdenum precursor composition of claim 6, wherein the reaction of the compound represented by the above Formula 3 with ethylbenzene involves a reflux reaction, and the reflux reaction is carried out at 100°C to 180°C for 10 hours to 100 hours.

9. A method for preparing a molybdenum-containing film, which comprises depositing a molybdenum-containing film using the molybdenum precursor composition of claim 1.

10. The method for preparing a molybdenum-containing film of claim 9, wherein the deposition of a molybdenum-containing film is carried out at a temperature of 300°C to 550°C by chemical vapor deposition (CVD) or atomic layer deposition (ALD).

11. A molybdenum-containing film, which is deposited using the molybdenum precursor composition of claim 1.
